# EUROPEAN PATENT SPECIFICATION

(11) **EP 1 606 846 B1**
(45) Date of publication and mention of the grant of the patent: **27.10.2010**
(21) Application number: 04758052.7
(22) Date of filing: 23.03.2004
(51) Int. Cl.: H01L 51/44

(54) **PHOTOVOLTAIC CELL WITH MESH ELECTRODE**
PHOTOVOLTAISCHE ZELLE MIT EINER MASCHENELEKTRODE
CELLULE PHOTOVOLTAIQUE A ELECTRODE A MAILLES

(30) Priority: 24.03.2003 US 395823; 26.11.2003 US 723554
(43) Date of publication of application: 21.12.2005
(73) Proprietor: Konarka Technologies, Inc., Lowell, MA 01852 (US)
(72) Inventor: GAUDIANA, Russell, Merrimack, NH 03054 (US); MONTELLO, Alan, West Newbury, MA 01985 (US)
(74) Representative: Peterreins, Frank
(86) International application number: PCT/US2004/008812
(87) International publication number: WO 2004/086462

(56) References cited:
- EP-A- 1 174 891
- WO-A-2004/019666
- JP-A- 2000 243 990
- JP-A- 2003 174 178
- US-A- 5 331 183
- US-B1- 6 291 763
- US-B1- 6 444 400
- SHAHEEN ET AL.: '2.5% efficient organic plastic solar cells' APPLIED PHYSICS LETTERS vol. 78, no. 6, 05 February 2001, pages 841 - 843, XP001020433

## Description

### TECHNICAL FIELD

The invention relates to photovoltaic cells that have a mesh electrode, as well as related systems.

### BACKGROUND

Photovoltaic cells are commonly used to transfer energy in the form of light into energy in the form of electricity. A typical photovoltaic cell includes a photoactive material disposed between two electrodes. Generally, light passes through one or both of the electrodes to interact with the photoactive material. As a result, the ability of one or both of the electrodes to transmit light (e.g., light at one or more wavelengths absorbed by a photoactive material) can limit the overall efficiency of a photovoltaic cell. In many photovoltaic cells, a film of semiconductive material (e.g., indium tin oxide) is used to form the electrode(s) through which light passes because, although the semiconductive material may have a lower electrical conductivity than electrically conductive materials, the semiconductive material can transmit more light than many electrically conductive materials.

There is an increasing interest in the development of photovoltaic technology due primarily to a desire to reduce consumption of and dependency on fossil fuel-based energy sources. Photovoltaic technology is also viewed by many as being an environmentally friendly energy technology. However, for photovoltaic technology to be a commercially feasible energy technology, the material and manufacturing costs of a photovoltaic system (a system that uses one or more photovoltaic cells to convert light to electrical energy) should be recoverable over some reasonable time frame. But, in some instances the costs (e.g., due to materials and/or manufacture) associated with practically designed photovoltaic systems have restricted their availability and use.

JP 2000243990 A which is regarded as the closest prior art discloses a cover film for the from surface of a solar cell that is prepared by sequentially laminating at least a heat-adhesive resin layer and a mesh-like electrode on a weather-resistant film. Organic solar cells can also be used.

EP 1 174 891 A2 describes a semiconductor for photoelectric conversion which exhibits a high open circuit voltage, as well as a photoelectric converting device which is excellent in photoelectric conversion characteristics and a photocell. In the semiconductor for photoelectric conversion, a compound is bonded at least to a surface of a semiconductor, and a dye is fixed to the compound bonded to the semiconductor through an interaction between an acidic group or an anionic group, formed by removing a proton from an acidic group, and a basic group and/or a group having a cationic group. The photoelectric converting device and the photocell include the semiconductor for photoelectric conversion.

US 6,444,400 B1 describes a method of making an electroconductive pattern on a support is disclosed. The support is provided with a polymer layer containing a polythiophene, a polyanion and a di- or polyhydroxy organic compound. The electroconductive pattern thus obtained can be used as an electronic circuit for making an electric or semiconductor device such as a printed circuit board, an integrated circuit, a display, an electroluminescent device or a photovoltaic cell.

WO 2004/019666 A1 which was post published describes a process for preparing a substantially transparent conductive layer configuration on a support, the layer configuration comprising in any order at least a first layer containing an intrinsically conductive polymer.

JP 2003174178 describes a solar battery panel comprising a wire layer made of a polishing type glass plate having a cross wire having improved strength and fire resistance, or cross wire glass plate and the like, a transparent glass layer made of transparent white plate glass or blew plate glass and the like, and a solar battery element layer where a solar battery element is sealed by filling an adhesive filling resin for laminated glass in the middle.

Shaheen et al. describes in "2.5% efficient organic plastic solar cells", Applied Physics Letters vol. 78, no. 6, 5 February 2001, pages 841 to 843, that the power conversion efficiency of organic photovoltaic devices based on a conjugated polymer/methanofullerene blend is dramatically affected by molecular morphology.

### SUMMARY

The invention relates to a photovoltaic cell according to claim 1. Preferred embodiments are described by the dependent claims.

The mesh electrode is formed of a material that provides good electrical conductivity (typically an electrically conductive material, but semiconductive materials may also be used), and the mesh electrode has an open area that is large enough to transmit enough light so that the photovoltaic cell is relatively efficient at transferring the light to electrical energy.

In some embodiments, two or more of the photovoltaic cells are electrically connected in parallel. In certain embodiments, two or more of the photovoltaic cells are electrically connected in series. In certain embodiments, two or more of the photovoltaic cells are electrically connected in parallel, and two or more different photovoltaic cells are electrically connected in series.

Embodiments can include one or more of the following aspects.

The mesh electrode can be a cathode or an anode. In some embodiments, a photovoltaic cell has a mesh cathode and a mesh anode.

The mesh electrode can be formed of wires. The wires can be formed of an electrically conductive material, such as an electrically conductive metal, an electrically conductive alloy, or an electrically conductive polymer. The wires can include a coating of an electrically conductive material (an electrically conductive metal, an electrically conductive alloy, or an electrically conductive polymer).

The mesh can be formed of an electrically conductive material (an electrically conductive metal, an electrically conductive alloy, or an electrically conductive polymer). The mesh can include a coating of an electrically conductive material (an electrically conductive metal, an electrically conductive alloy, or an electrically conductive polymer).

The electron acceptor material can be, for example, formed of fullerenes, inorganic nanoparticles, discotic liquid crystals, carbon nanorods, inorganic nanorods, oxadiazoles, or polymers containing moieties capable of accepting electrons or forming stable anions (e.g., polymers containing CN groups, polymers containing CF₃ groups). In some embodiments, the electron acceptor material is a substituted fullerene.

The electron donor material can be formed of discotic liquid crystals, polythiophenes, polyphenylenes, polyphenylvinylenes, polysilanes, polythienylvinylenes and/or polyisothianaphthalenes. In some embodiments, the electron donor material is poly(3-hexylthiophene).

A photovoltaic cell can further include a hole blocking layer between the active layer and an anode (e.g., a mesh anode or a non-mesh anode). The hole blocking layer can be formed of, for example, LiF or metal oxides.

A photovoltaic cell can also include a hole carrier layer between the active layer and the cathode (e.g., a mesh cathode or non-mesh cathode). The hole carrier layer can be formed of, for example, polythiophenes, polyanilines, and/or polyvinylcarbazoles, or polyions of one or more of these polymers.

In some embodiments, the hole carrier layer is in contact with a substrate that supports that cathode.

In certain embodiments, the photovoltaic cell further includes an adhesive material between the substrate that supports the cathode and the hole carrier layer. In general, an adhesive material can adhere material layers in contact with the adhesive during standard operating conditions of a photovoltaic cell. In some embodiments, an adhesive includes one or more thermoplastics, thermosets, or pressure sensitive adhesives.

In some embodiments, the photovoltaic cell or photovoltaic system is electrically connected to an external load.

Embodiments can provide one or more of the following advantages.

In some embodiments, a mesh electrode can provide good electrical conductivity because it is formed of an electrically conductive material (as opposed to a semiconductor material), while at the same time having a structure (e.g., a mesh structure) that allows a sufficient amount of light therethrough so that the photovoltaic cell is more efficient at converting light into electrical energy.

In certain embodiments, a mesh electrode can be sufficiently flexible to allow the mesh electrode to be incorporated in the photovoltaic cell using a continuous, roll-to-roll manufacturing process, thereby allowing manufacture of the photovoltaic cell at relatively high throughput.

Using one or more mesh electrodes can reduce the cost and/or complexity associated with manufacturing a photovoltaic cell.

A photovoltaic cell having one or more mesh electrodes can transfer energy in the form of light to energy in the form of electricity in a more efficient manner compared to certain semiconductive electrodes.

Other features and advantages will be apparent from the description, drawings and from the claims.

### DESCRIPTION OF DRAWINGS

Fig. 1 is a cross-sectional view of an embodiment of a photovoltaic cell;
Fig. 2 is an elevational view of an embodiment of a mesh electrode;
Fig. 3 is a cross-sectional view of the mesh electrode of 2;
Fig. 4 is a cross-sectional view of a portion of a mesh electrode;
Fig. 5 is a cross-sectional view of another embodiment of a photovoltaic cell;
Fig. 6 is a schematic of a system containing multiple photovoltaic cells electrically connected in series; and
Fig. 7 is a schematic of a system containing multiple photovoltaic cells electrically connected in parallel.

### DETAILED DESCRIPTION

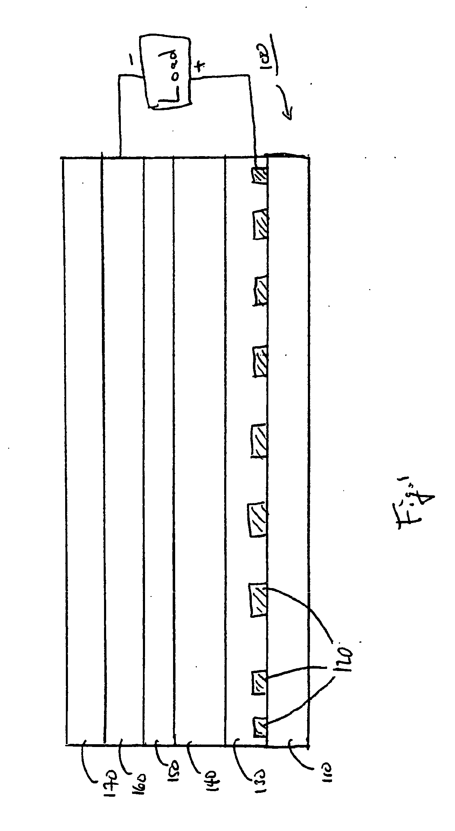

Fig. 1 shows a cross-sectional view of a photovoltaic cell 100 that includes a transparent substrate 110, a mesh cathode 120, a hole carrier layer 130, a photoactive layer (containing an electron acceptor material and an electron donor material) 140, a hole blocking layer 150, an anode 160, and a substrate 170.

In general, during use, light impinges on the surface of substrate 110, and passes through substrate 110, the openings in cathode 120 and hole carrier layer 130. The light then interacts with photoactive layer 140, causing electrons to be transferred from the electron donor material in layer 140 to the electron acceptor material in layer 140. The electron acceptor material then transmits the electrons through hole blocking layer 150 to anode 160, and the electron donor material transfers holes through hole carrier layer 130 to mesh cathode 120. Anode 160 and mesh cathode 120 are in electrical connection via an external load so that electrons pass from anode 160, through the load, and to cathode 120.

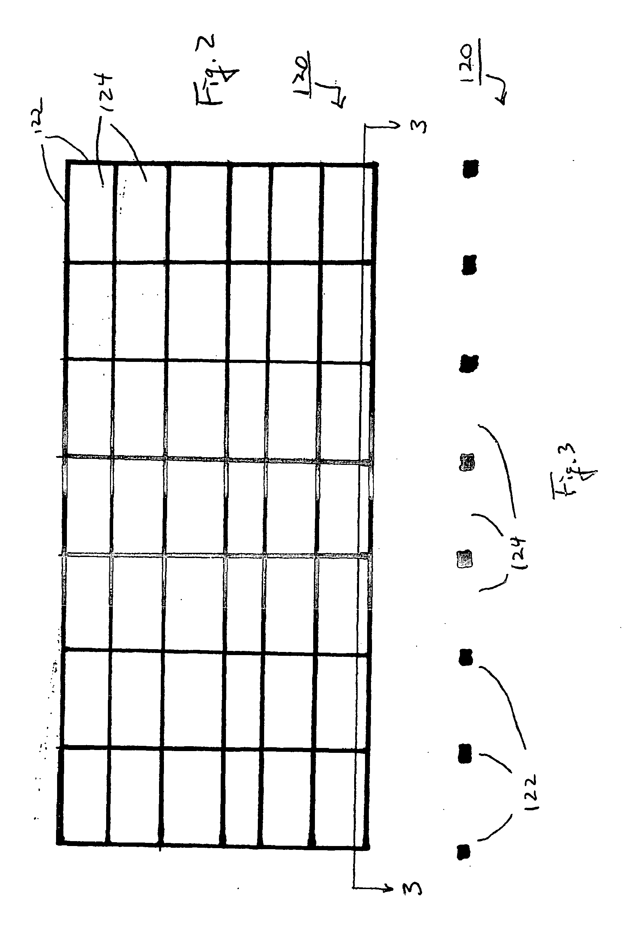

As shown in Figs. 2 and 3, mesh cathode 120 includes solid regions 122 and open regions 124. In general, regions 122 are formed of electrically conducting material so that mesh cathode 120 can allow light to pass therethrough via regions 124 and conduct electrons via regions 122.

The area of mesh cathode 120 occupied by open regions 124 (the open area of mesh cathode 120) can be selected as desired. Generally, the open area of mesh cathode 120 is at least about 10% (e.g., at least about 20%, at least about 30%, at least about 40%, at least about 50%, at least about 60%, at least about 70%, at least about 80%) and/or at most about 99% (e.g., at most about 95%, at most about 90%, at most about 85%) of the total area of mesh cathode 120.

Mesh cathode 120 can be prepared in various ways. In some embodiments, mesh cathode 120 is a woven mesh formed by weaving wires of material that form solid regions 122. The wires can be woven using, for example, a plain weave, a Dutch, weave, a twill weave, a Dutch twill weave, or combinations thereof. In certain embodiments, mesh cathode 120 is formed of a welded wire mesh. In some embodiments, mesh cathode 120 is an expanded mesh formed. An expanded metal mesh can be prepared, for example, by removing regions 124 (e.g., via laser removal, via chemical etching, via puncturing) from a sheet of material (e.g., an electrically conductive material, such as a metal), followed by stretching the sheet (e.g., stretching the sheet in two dimensions). In certain embodiments, mesh cathode 120 is a metal sheet formed by removing regions 124 (e.g., via laser removal, via chemical etching, via puncturing) without subsequently stretching the sheet.

In certain embodiments, solid regions 122 are formed entirely of an electrically conductive material (e.g., regions 122 are formed of a substantially homogeneous material that is electrically conductive). Examples of electrically conductive materials that can be used in regions 122 include electrically conductive metals, electrically conductive alloys and electrically conductive polymers. Exemplary electrically conductive metals include gold, silver, copper, nickel, palladium, platinum and titanium. Exemplary electrically conductive alloys include stainless steel (e.g., 332 stainless steel, 316 stainless steel), alloys of gold, alloys of silver, alloys of copper, alloys of nickel, alloys of palladium, alloys of platinum and alloys of titanium. Exemplary electrically conducting polymers include polythiophenes (e.g., poly(3,4-ethelynedioxythiophene) (PEDOT)), polyanilines (e.g., doped polyanilines), polypyrroles (e.g., doped polypyrroles). In some embodiments, combinations of electrically conductive materials are used.

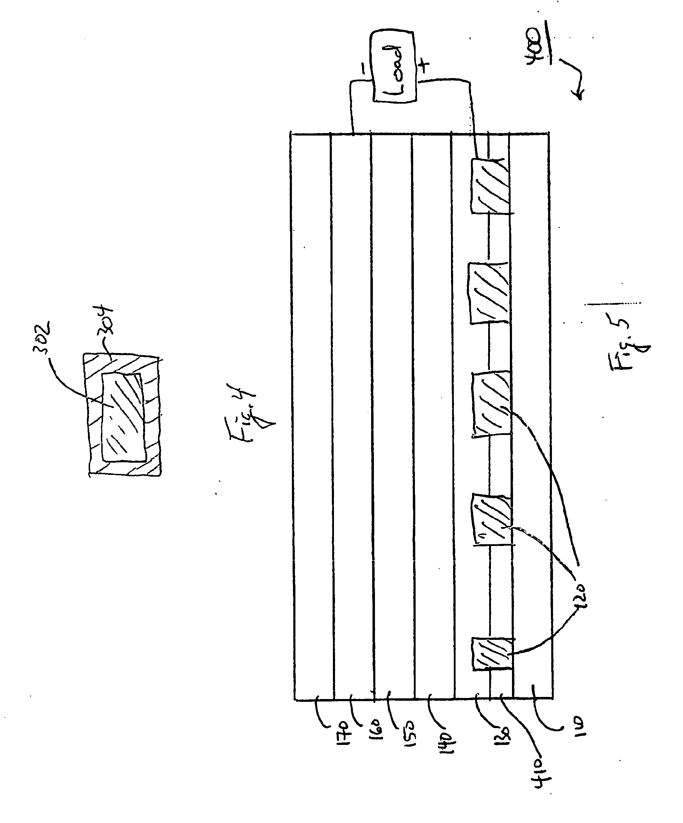

As shown in Fig. 4, in some embodiments, solid regions 122 are formed of a material 302 that is coated with a different material 304 (e.g., using metallization, using vapor deposition). In general, material 302 can be formed of any desired material (e.g., an electrically insulative material, an electrically conductive material, or a semiconductive material), and material 304 is an electrically conductive material. Examples of electrically insulative material from which material 302 can be formed include textiles, optical fiber materials, polymeric materials (e.g., a nylon) and natural materials (e.g., flax, cotton, wool, silk). Examples of electrically conductive materials from which material 302 can be formed include the electrically conductive materials disclosed above. Examples of semiconductive materials from which material 302 can be formed include indium tin oxide, fluorinated tin oxide, tin oxide and zinc oxide. In some embodiments, material 302 is in the form of a fiber, and material 304 is an electrically conductive material that is coated on material 302. In certain embodiments, material 302 is in the form of a mesh (see discussion above) that, after being formed into a mesh, is coated with material 304. As an example, material 302 can be an expanded metal mesh, and material 304 can be PEDOT that is coated on the expanded metal mesh.

Generally, the maximum thickness of mesh cathode 120 (i.e., the maximum thickness of mesh cathode 120 in a direction substantially perpendicular to the surface of substrate 110 in contact with mesh cathode 120) should be less than the total thickness of hole carrier layer 130. Typically, the maximum thickness of mesh cathode 120 is at least 0.1 micron (e.g., at least about 0.2 micron, at least about 0.3 micron, at least about 0.4 micron, at least about 0.5 micron, at least about 0.6 micron, at least about 0.7 micron, at least about 0.8 micron, at least about 0.9 micron, at least about one micron) and/or at most about 10 microns (e.g., at most about nine microns, at most about eight microns, at most about seven microns, at most about six microns, at most about five microns, at most about four microns, at most about three microns, at most about two microns).

While shown in Fig. 2 as having a rectangular shape, open regions 124 can generally have any desired shape (e.g., square, circle, semicircle, triangle, diamond, ellipse, trapezoid, irregular shape). In some embodiments, different open regions 124 in mesh cathode 120 can have different shapes.

Although shown in Fig. 3 as having square cross-sectional shape, solid regions 122 can generally have any desired shape (e.g., rectangle, circle, semicircle, triangle, diamond, ellipse, trapezoid, irregular shape). In some embodiments, different solid regions 122 in mesh cathode 120 can have different shapes.

In some embodiments, mesh cathode 120 is flexible (e.g., sufficiently flexible to be incorporated in photovoltaic cell 100 using a continuous, roll-to-roll manufacturing process). In certain embodiments, mesh cathode 120 is semi-rigid or inflexible. In some embodiments, different regions of mesh cathode 120 can be flexible, semi-rigid or inflexible (e.g., one or more regions flexible and one or more different regions semi-rigid, one or more regions flexible and one or more different regions inflexible).

Substrate 110 is generally formed of a transparent material. As referred to herein, a transparent material is a material which, at the thickness used in a photovoltaic cell 100, transmits at least about 60% (e.g., at least about 70%, at least about 75%, at least about 80%, at least about 85%) of incident light at a wavelength or a range of wavelengths used during operation of the photovoltaic cell. Exemplary materials from which substrate 110 can be formed include polyethylene terephthalates, polyimides, polyethylene naphthalates, polymeric hydrocarbons, cellulosic polymers, polycarbonates, polyamides, polyethers and polyether ketones. In certain embodiments, the polymer can be a fluorinated polymer. In some embodiments, combinations of polymeric materials are used. In certain embodiments, different regions of substrate 110 can be formed of different materials.

In general, substrate 110 can be flexible, semi-rigid or rigid (e.g., glass). In some embodiments, substrate 110 has a flexural modulus of less than about 5,000 megaPascals. In certain embodiments, different regions of substrate 110 can be flexible, semi-rigid or inflexible (e.g., one or more regions flexible and one or more different regions semi-rigid, one or more regions flexible and one or more different regions inflexible).

Typically, substrate 110 is at least about one micron (e.g., at least about five microns, at least about 10 microns) thick and/or at most about 1,000 microns (e.g., at most about 500 microns thick, at most about 300 microns thick, at most about 200 microns thick, at most about 100 microns, at most about 50 microns) thick.

Generally, substrate 110 can be colored or non-colored. In some embodiments, one or more portions of substrate 110 is/are colored while one or more different portions of substrate 110 is/are non-colored.

Substrate 110 can have one planar surface (e.g., the surface on which light impinges), two planar surfaces (e.g., the surface on which light impinges and the opposite surface), or no planar surfaces. A non-planar surface of substrate 110 can, for example, be curved or stepped. In some embodiments, a non-planar surface of substrate 110 is patterned (e.g., having patterned steps to form a Fresnel lens, a lenticular lens or a lenticular prism).

Hole carrier layer 130 is generally formed of a material that, at the thickness used in photovoltaic cell 100, transports holes to mesh cathode 120 and substantially blocks the transport of electrons to mesh cathode 120. Examples of materials from which layer 130 can be formed include polythiophenes (e.g., PEDOT), polyanilines, polyvinylcarbazoles, polyphenylenes, polyphenylvinylenes, polysilanes, polythienylenevinylenes and/or polyisothianaphthanenes. In some embodiments, hole carrier layer 130 can include combinations of hole carrier materials.

In general, the distance between the upper surface of hole carrier layer 130 (i.e., the surface of hole carrier layer 130 in contact with active layer 140) and the upper surface of substrate 110 (i.e., the surface of substrate 110 in contact with mesh electrode 120) can be varied as desired. Typically, the distance between the upper surface of hole carrier layer 130 and the upper surface of mesh cathode 120 is at least 0.01 micron (e.g., at least about 0.05 micron, at least about 0.1 micron, at least about 0.2 micron, at least about 0.3 micron, at least about 0.5 micron) and/or at most about five microns (e.g., at most about three microns, at most about two microns, at most about one micron). In some embodiments, the distance between the upper surface of hole carrier layer 130 and the upper surface of mesh cathode 120 is from about 0.01 micron to about 0.5 micron.

Active layer 140 generally contains an electron acceptor material and an electron donor material.

Examples of electron acceptor materials include formed of fullerenes, oxadiazoles, carbon nanorods, discotic liquid crystals, inorganic nanoparticles (e.g., nanoparticles formed of zinc oxide, tungsten oxide, indium phosphide, cadmium selenide and/or lead sulphide), inorganic nanorods (e.g., nanorods formed of zinc oxide, tungsten oxide, indium phosphide, cadmium selenide and/or lead sulphide), or polymers containing moieties capable of accepting electrons or forming stable anions (e.g., polymers containing CN groups, polymers containing CF₃ groups). In some embodiments, the electron acceptor material is a substituted fullerene (e.g., PCBM). In some embodiments, active layer 140 can include a combination of electron acceptor materials.

Examples of electron donor materials include discotic liquid crystals, polythiophenes, polyphenylenes, polyphenylvinylenes, polysilanes, polythienylvinylenes, and polyisothianaphthalenes. In some embodiments, the electron donor material is ply(3-hexylthiophene). In certain embodiments, active layer 140 can include a combination of electron donor materials.

Generally, active layer 140 is sufficiently thick to be relatively efficient at absorbing photons impinging thereon to form corresponding electrons and holes, and sufficiently thin to be relatively efficient at transporting the holes and electrons to layers 130 and 150, respectively. In certain embodiments, layer 140 is at least 0.05 micron (e.g., at least about 0.1 micron, at least about 0.2 micron, at least about 0.3 micron) thick and/or at most about one micron (e.g., at most about 0.5 micron, at most about 0.4 micron) thick. In some embodiments, layer 140 is from about 0.1 micron to about 0.2 micron thick.

Hole blocking layer 150 is general formed of a material that, at the thickness used in photovoltaic cell 100, transports electrons to anode 160 and substantially blocks the transport of holes to anode 160. Examples of materials from which layer 150 can be formed include LiF and metal oxides (e.g., zinc oxide, titanium oxide).

Typically, hole blocking layer 150 is at least 0.02 micron (e.g., at least about 0.03 micron, at least about 0.04 micron, at least about 0.05 micron) thick and/or at most about 0.5 micron (e.g., at most about 0.4 micron, at most about 0.3 micron, at most about 0.2 micron, at most about 0.1 micron) thick.

Anode 160 is generally formed of an electrically conductive material, such as one or more of the electrically conductive materials noted above. In some embodiments, anode 160 is formed of a combination of electrically conductive materials.

Substrate 170 can be formed of a transparent material or a non-transparent material. For example, in embodiments in which photovoltaic cell uses light that passes through anode 160 during use, substrate 170 is desirably formed of a transparent material.

Exemplary materials from which substrate 170 can be formed include polyethylene terephthalates, polyimides, polyethylene naphthalates, polymeric hydrocarbons, cellulosic polymers, polycarbonates, polyamides, polyethers and polyether ketones. In certain embodiments, the polymer can be a fluorinated polymer. In some embodiments, combinations of polymeric materials are used. In certain embodiments, different regions of substrate 110 can be formed of different materials.

In general, substrate 170 can be flexible, semi-rigid or rigid. In some embodiments, substrate 170 has a flexural modulus of less than about 5,000 megaPascals. In certain embodiments, different regions of substrate 170 can be flexible, semi-rigid or inflexible (e.g., one or more regions flexible and one or more different regions semi-rigid, one or more regions flexible and one or more different regions inflexible). Generally, substrate 170 is substantially non-scattering.

Typically, substrate 170 is at least about one micron (e.g., at least about five microns, at least about 10 microns) thick and/or at most about 200 microns (e.g., at most about 100 microns, at most about 50 microns) thick.

Generally, substrate 170 can be colored or non-colored. In some embodiments, one or more portions of substrate 170 is/are colored while one or more different portions of substrate 170 is/are non-colored.

Substrate 170 can have one planar surface (e.g., the surface of substrate 170 on which light impinges in embodiments in which during use photovoltaic cell 100 uses light that passes through anode 160), two planar surfaces (e.g., the surface of substrate 170 on which light impinges in embodiments in which during use photovoltaic cell 100 uses light that passes through anode 160 and the opposite surface of substrate 170), or no planar surfaces. A non-planar surface of substrate 170 can, for example, be curved or stepped. In some embodiments, a non-planar surface of substrate 170 is patterned (e.g., having patterned steps to form a Fresnel lens, a lenticular lens or a lenticular prism).

Fig. 5 shows a cross-sectional view of a photovoltaic cell 400 that includes an adhesive layer 410 between substrate 110 and hole carrier layer 130.

Generally, any material capable of holding mesh cathode 130 in place can be used in adhesive layer 410. In general, adhesive layer 410 is formed of a material that is transparent at the thickness used in photovoltaic cell 400. Examples of adhesives include epoxies and urethanes. Examples of commercially available materials that can be used in adhesive layer 410 include Bynel^{™} adhesive (DuPont) and 615 adhesive (3M). In some embodiments, layer 410 can include a fluorinated adhesive. In certain embodiments, layer 410 contains an electrically conductive adhesive. An electrically conductive adhesive can be formed of, for example, an inherently electrically conductive polymer, such as the electrically conductive polymers disclosed above (e.g., PEDOT). An electrically conductive adhesive can be also formed of a polymer (e.g., a polymer that is not inherently electrically conductive) that contains one or more electrically conductive materials (e.g., electrically conductive particles). In some embodiments, layer 410 contains an inherently electrically conductive polymer that contains one or more electrically conductive materials.

In some embodiments, the thickness of layer 410 (i.e., the thickness of layer 410 in a direction substantially perpendicular to the surface of substrate 110 in contact with layer 410) is less thick than the maximum thickness of mesh cathode 120. In some embodiments, the thickness of layer 410 is at most about 90% (e.g., at most about 80%, at most about 70%, at most about 60%, at most about 50%, at most about 40%, at most about 30%, at most about 20%) of the maximum thickness of mesh cathode 120. In certain embodiments, however, the thickness of layer 410 is about the same as, or greater than, the maximum thickness of mesh cathode 130.

In general, a photovoltaic cell having a mesh cathode can be manufactured as desired.

In some embodiments, a photovoltaic cell can be prepared as follows. Electrode 160 is formed on substrate 170 using conventional techniques, and hole-blocking layer 150 is formed on electrode 160 (e.g., using a vacuum deposition process or a solution coating process). Active layer 140 is formed on hole-blocking layer 150 (e.g., using a solution coating process, such as slot coating, spin coating or gravure coating). Hole carrier layer 130 is formed on active layer 140 (e.g., using a solution coating process, such as slot coating, spin coating or gravure coating). Mesh cathode 120 is partially disposed in hole carrier layer 130 (e.g., by disposing mesh cathode 120 on the surface of hole carrier layer 130, and pressing mesh cathode 120). Substrate 110 is then formed on mesh cathode 120 and hole carrier layer 130 using conventional methods.

In certain embodiments, a photovoltaic cell can be prepared as follows. Electrode 160 is formed on substrate 170 using conventional techniques, and hole-blocking layer 150 is formed on electrode 160 (e.g., using a vacuum deposition or a solution coating process). Active layer 140 is formed on hole-blocking layer 150 (e.g., using a solution coating process, such as slot coating, spin coating or gravure coating). Hole carrier layer 130 is formed on active layer 140 (e.g., using a solution coating process, such as slot coating, spin coating or gravure coating). Adhesive layer 410 is disposed on hole carrier layer 130 using conventional methods. Mesh cathode 120 is partially disposed in adhesive layer 410 and hole carrier layer 130 (e.g., by disposing mesh cathode 120 on the surface of adhesive layer 410, and pressing mesh cathode 120). Substrate 110 is then formed on mesh cathode 120 and adhesive layer 410 using conventional methods.

While the foregoing processes involve partially disposing mesh cathode 120 in hole carrier layer 130, in some embodiments, mesh cathode 120 is formed by printing the cathode material on the surface of carrier layer 130 or adhesive layer 410 to provide an electrode having the open structure shown in the figures. For example, mesh cathode 120 can be printed using an inkjet printer, a screen printer, or gravure printer. The cathode material can be disposed in a paste which solidifies upon heating or radiation (e.g., UV radiation, visible radiation, IR radiation, electron beam radiation). The cathode material can be, for example, vacuum deposited in a mesh pattern through a screen or after deposition it may be patterned by photolithography.

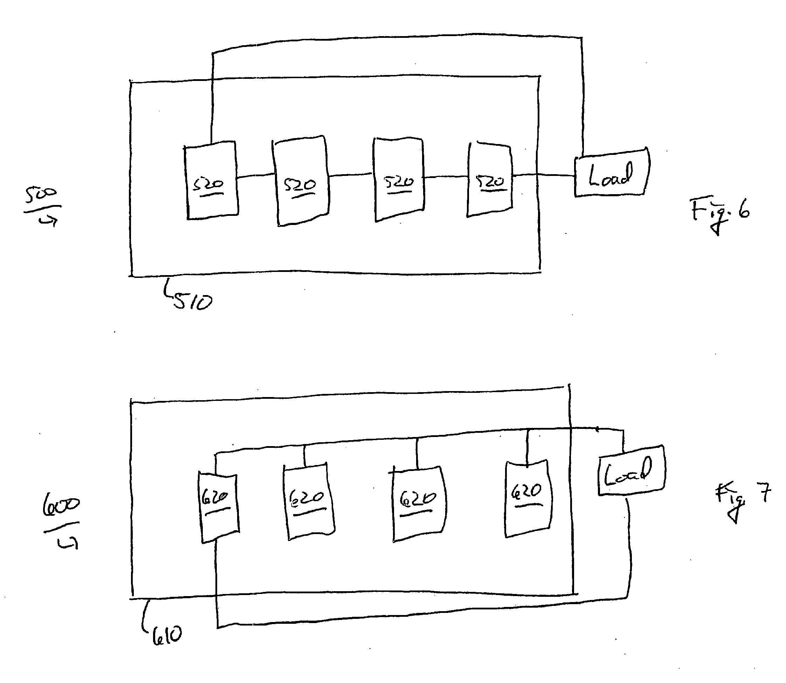

Multiple photovoltaic cells can be electrically connected to form a photovoltaic system. As an example, Fig. 6 is a schematic of a photovoltaic system 500 having a module 510 containing photovoltaic cells 520. Cells 520 are electrically connected in series, and system 500 is electrically connected to a load. As another example, Fig. 7 is a schematic of a photovoltaic system 600 having a module 610 that contains photovoltaic cells 620. Cells 620 are electrically connected in parallel, and system 600 is electrically connected to a load. In some embodiments, some (e.g., all) of the photovoltaic cells in a photovoltaic system can have one or more common substrates. In certain embodiments, some photovoltaic cells in a photovoltaic system are electrically connected in series, and some of the photovoltaic cells in the photovoltaic system are electrically connected in parallel.

While certain embodiments have been disclosed, other embodiments are also possible.

As another example, while cathodes formed of mesh have been described, in some embodiments a mesh anode can be used. This can be desirable, for example, when light transmitted by the anode is used. In certain embodiments, both a mesh cathode and a mesh anode are used. This can be desirable, for example, when light transmitted by both the cathode and the anode is used.

As an example, while embodiments have generally been described in which light that is transmitted via the cathode side of the cell is used, in certain embodiments light transmitted by the anode side of the cell is used (e.g., when a mesh anode is used). In some embodiments, light transmitted by both the cathode and anode sides of the cell is used (when a mesh cathode and a mesh anode are used).

As a further example, while electrodes (e.g., mesh electrodes, non-mesh electrodes) have been described as being formed of electrically conductive materials, in some embodiments a photovoltaic cell may include one or more electrodes (e.g., one or more mesh electrodes, one or more non-mesh electrodes) formed of a semiconductive material. Examples of semiconductive materials include indium tin oxide, fluorinated tin oxide, tin oxide and zinc oxide.

As an additional example, in some embodiments, one or more semiconductive materials can be disposed in the open regions of a mesh electrode (e.g., in the open regions of a mesh cathode, in the open regions of a mesh anode, in the open regions of a mesh cathode and the open regions of a mesh anode). Examples of semiconductive materials include tin oxide, fluorinated tin oxide, tin oxide and zinc oxide. Typically, the semiconductive material disposed in an open region of a mesh electrode is transparent at the thickness used in the photovoltaic cell.

As another example, in certain embodiments, a protective layer can be applied to one or both of the substrates. A protective layer can be used to, for example, keep contaminants (e.g., dirt, water, oxygen, chemicals) out of a photovoltaic cell and/or to ruggedize the cell. In certain embodiments, a protective layer can be formed of a polymer (e.g., a fluorinated polymer).

As a further example, while certain types of photovoltaic cells have been described that have one or more mesh electrodes, one or more mesh electrodes (mesh cathode, mesh anode, mesh cathode and mesh anode) can be used in other types of photovoltaic cells as well. Examples of such photovoltaic cells include photoactive cells with an active material formed of amorphous silicon, cadmium selenide, cadmium telluride, copper indium sulfide, and copper indium gallium arsenide.

As an additional example, while described as being formed of different materials, in some embodiments materials 302 and 304 are formed of the same material.

As another example, although shown in Fig. 4 as being formed of one material coated on a different material, in some embodiments solid regions 122 can be formed of more than two coated materials (e.g., three coated materials, four coated materials, five coated materials, six coated materials.

Other embodiments are in the claims.

## Claims

1. A photovoltaic cell (100, 520, 620), comprising:
a first electrode (160);
a mesh electrode (120); and
an active layer (140) between the first and mesh electrodes (160, 120),
**characterized by**
the active layer (140) comprising:
an electron acceptor material; and
an electron donor material; and
the mesh electrode (120) comprising a woven mesh.

2. The photovoltaic cell (100, 520, 620) of claim 1, wherein the mesh electrode (120) is a cathode.

3. The photovoltaic cell (100, 520, 620) of claim 1, wherein the mesh electrode (120) is an anode.

4. The photovoltaic cell (100, 520, 620) of claim 1, wherein the mesh comprises an electrically conductive material.

5. The photovoltaic cell (100, 520, 620) of claim 4, wherein the electrically conductive material is selected from the group consisting of metals, alloys, polymers and combinations thereof.

6. The photovoltaic cell (100, 520, 620) of claim 1, wherein the mesh electrode (120) comprises wires (122).

7. The photovoltaic cell (100, 520, 620) of claim 6, wherein the wires (122) comprise an electrically conductive material.

8. The photovoltaic cell (100, 520, 620) of claim 7, wherein the electrically conductive material is selected from the group consisting of metals, alloys, polymers and combinations thereof.

9. The photovoltaic cell (100, 520, 620) of claim 6, wherein the wires (122) comprise a coating (304) including an electrically conductive material.

10. The photovoltaic cell (100, 520, 620) of claim 9, wherein the electrically conductive material is selected from the group consisting of metals, alloys, polymers and combinations thereof.

11. The photovoltaic cell (100, 520, 620) of claim 10, wherein the wires (122) are formed of electrically insulative material (302) coated with the coating (304).

12. The photovoltaic cell (100, 520, 620) of claim 1, wherein the electron acceptor material comprises a material selected from the group consisting of fullerenes, inorganic nanoparticles, oxadiazoles, discotic liquid crystals, carbon nanorods, inorganic nanorods, polymers containing CN groups, polymers containing CF₃ groups and combinations thereof.

13. The photovoltaic cell (100, 520, 620) of claim 1, wherein the electron acceptor material comprises a substituted fullerene.

14. The photovoltaic cell (100, 520, 620) of claim 1, wherein the electron donor material comprises a material selected from the group consisting of discotic liquid crystals, polythiophenes, polyphenylenes, polyphenylvinylenes, polysilanes, polythienylvinylenes and polyisothianaphthalenes.

15. The photovoltaic cell (100, 520, 620) of claim 1, wherein the electron donor material comprises poly(3-hexylthiophene).

16. The photovoltaic cell (100, 520, 620) of claim 1, further comprising a hole blocking layer (150) between the active layer (140) and the first electrode (160).

17. The photovoltaic cell (100, 520, 620) of claim 16, wherein the hole blocking layer (150) comprises a material selected from the group consisting of LiF, metal oxides and combinations thereof.

18. The photovoltaic cell (100, 520, 620) of claim 1, further comprising a hole blocking layer (150) between the active layer (140) and the mesh electrode (120).

19. The photovoltaic cell (100, 520, 620) of claim 18, wherein the hole blocking layer (150) comprises a material selected from the group consisting of LiF, metal oxides and combinations thereof.

20. The photovoltaic cell (100, 520, 620) of claim 1, further comprising a hole carrier layer (130) between the active layer (140) and the mesh electrode (120).

21. The photovoltaic cell (100, 520, 620) of claim 20, wherein the hole carrier layer (130) comprises a material selected from the group consisting of polythiophenes, polyanilines, polyvinylcarbazoles, polyphenylenes, polyphenylvinylenes, polysilanes, polythienylenevinylenes, polyisothianaphthanenes and combinations thereof.

22. The photovoltaic cell (100, 520, 620) of claim 1, further comprising a hole carrier layer between the active layer (140) and the first electrode.

23. The photovoltaic cell (100, 520, 620) of claim 22, wherein the hole carrier layer comprises a material selected from the group consisting of polythiophenes, polyanilines, polyvinylcarbazoles, polyphenylenes, polyphenylvinylenes, polysilanes, polythienylenevinylenes, polyisothianaphthanenes and combinations thereof.

24. The photovoltaic cell (100, 520, 620) of claim 19 wherein the first electrode comprises a mesh electrode.

25. The photovoltaic cell (100, 520, 620) of any of claims 1 or 4 to 11, further comprising:
a hole blocking layer (150) between the first electrode (160) and the active layer (140); and
a hole carrier layer (130) between the mesh electrode (120) and the active layer (140).

26. The photovoltaic cell (100, 520, 620) of claim 25, wherein the hole carrier layer (130) comprises a material selected from the group consisting of polythiophenes, polyanilines, polyvinylcarbazoles, polyphenylenes, polyphenylvinylenes, polysilanes, polythienylenevinylenes, polyisothianaphthanenes and combinations thereof.

27. The photovoltaic cell (100, 520, 620) of claim 26, wherein the hole blocking layer (150) comprises a material selected from the group consisting of LiF, metal oxides and combinations thereof.

28. The photovoltaic cell (100, 520, 620) of claim 25, wherein the hole blocking layer (150) comprises a material selected from the group consisting of LiF, metal oxides and combinations thereof.

29. The photovoltaic cell (100, 520, 620) of claim 25, wherein the first electrode comprises a mesh electrode.

30. The photovoltaic cell (100, 520, 620) of claim 25, further comprising a substrate (110) supporting the mesh electrode (120).

31. The photovoltaic cell (100, 520, 620) of claim 30, further comprising an adhesive material between the substrate (110) and the hole carrier layer (130).

32. The photovoltaic cell (100, 520, 620) of claim 30, wherein the hole carrier layer (130) is in contact with the substrate (110).

33. A photovoltaic system (500, 600) comprising a plurality of photovoltaic cells (520, 620) of claim 1 or 25, at least some of the plurality of photovoltaic cells (520, 620) being electrically connected.

34. The photovoltaic system (500, 600) of claim 33, wherein all of the plurality of photovoltaic cells (520, 620) are electrically connected.

35. The photovoltaic system (600) of claim 33, wherein at least some of the electrically connected photovoltaic cells (620) are electrically connected in parallel.

36. The photovoltaic system (500) of claim 33, wherein at least some of the electrically connected photovoltaic cells (520) are electrically connected in series.

37. The photovoltaic system (500, 600) of claim 33, wherein
at least some of the electrically connected photovoltaic cells (520, 620) are electrically connected in parallel to a load.

## Patentansprüche

1. Photovoltaische Zelle (100, 520, 620), umfassend:
eine erste Elektrode (160);
eine Netzelektrode (120); und
eine aktive Schicht (140) zwischen der ersten und der Netzelektrode (140, 120), **gekennzeichnet dadurch,**
**dass** die aktive Schicht (140) umfasst:
ein Elektronenakzeptormaterial; und
ein Elektronendonatormaterial; und
**dass** die Netzelektrode (120) ein gewebtes Netz umfasst.

2. Photovoltaische Zelle (100, 520, 620) gemäß Anspruch 1, wobei die Netzelektrode (120) eine Kathode ist.

3. Photovoltaische Zelle (100, 520, 620) gemäß Anspruch 1, wobei die Netzelektrode (120) eine Anode ist.

4. Photovoltaische Zelle (100, 520, 620) gemäß Anspruch 1, wobei die Netzelektrode ein elektrisch leitfähiges Material umfasst.

5. Photovoltaische Zelle (100, 520, 620) gemäß Anspruch 4, wobei das elektrisch leitfähige Material ausgewählt ist aus der Gruppe bestehend aus Metallen, Legierungen, Polymeren und Kombinationen daraus.

6. Photovoltaische Zelle (100, 520, 620) gemäß Anspruch 1, wobei die Netzelektrode (120) Drähte (122) umfasst.

7. Photovoltaische Zelle (100, 520, 620) gemäß Anspruch 6, wobei die Drähte (122) ein elektrisch leitfähiges Material umfassen.

8. Photovoltaische Zelle (100, 520, 620) gemäß Anspruch 7, wobei das elektrisch leitfähige Material ausgewählt ist aus der Gruppe bestehend aus Metallen, Legierungen, Polymeren und Kombinationen daraus.

9. Photovoltaische Zelle (100, 520, 620) gemäß Anspruch 6, wobei die Drähte (122) eine Beschichtung (304) umfassen, die ein elektrisch leitfähiges Material einschließt.

10. Photovoltaische Zelle (100, 520, 620) gemäß Anspruch 9, wobei das elektrisch leitfähige Material ausgewählt ist aus der Gruppe bestehend aus Metallen, Legierungen, Polymeren und Kombinationen daraus.

11. Photovoltaische Zelle (100, 520, 620) gemäß Anspruch 10, wobei die Drähte (122) aus elektrisch isolierendem Material (302) gebildet sind, beschichtet mit der Beschichtung (304).

12. Photovoltaische Zelle (100, 520, 620) gemäß Anspruch 1, wobei das Elektronenakzeptormaterial ein Material umfasst ausgewählt aus der Gruppe bestehend aus Fullerenen, anorganischen Nanopartikeln, Oxadiazolen, diskoiden Flüssigkristallen, Kohlenstoffnanoröhrchen, anorganischen Nanoröhrchen, Polymeren, die CN-Gruppen beinhalten, Polymeren, die CF₃-Gruppen beinhalten und Kombinationen daraus.

13. Photovoltaische Zelle (100, 520, 620) gemäß Anspruch 1, wobei das Elektronenakzeptormaterial ein substituiertes Fulleren umfasst.

14. Photovoltaische Zelle (100, 520, 620) gemäß Anspruch 1, wobei das Elektronendonatormaterial ein Material umfasst ausgewählt aus der Gruppe bestehend aus diskoiden Flüssigkristallen, Polythiophenen, Polyphenylenen, Polyphenylvinylenen, Polysilanen, Polythienylvinylenen und Polyisothianaphthalenen.

15. Photovoltaische Zelle (100, 520, 620) gemäß Anspruch 1, wobei das Elektronendonatormaterial Poly(3-Hexylthiophen) umfasst.

16. Photovoltaische Zelle (100, 520, 620) gemäß Anspruch 1, weiter umfassend eine Lochblockierende-Schicht (150) zwischen der aktiven Schicht (140) und der ersten Elektrode (160).

17. Photovoltaische Zelle (100, 520, 620) gemäß Anspruch 16, wobei die Lochblockierende-Schicht (150) ein Material umfasst ausgewählt aus der Gruppe bestehend aus LiF, Metalloxiden und Kombinationen daraus.

18. Photovoltaische Zelle (100, 520, 620) gemäß Anspruch 1, weiter umfassend eine Lochblockierende-Schicht (150) zwischen der aktiven Schicht (140) und der Netzelektrode (120).

19. Photovoltaische Zelle (100, 520, 620) gemäß Anspruch 18, wobei die Lochblockierende-Schicht (150) ein Material umfasst ausgewählt aus der Gruppe bestehend aus LiF, Metalloxiden und Kombinationen daraus.

20. Photovoltaische Zelle (100, 520, 620) gemäß Anspruch 1, weiter umfassend eine Lochtransportschicht (130) zwischen der aktiven Schicht (140) und der Netzelektrode (120).

21. Photovoltaische Zelle (100, 520, 620) gemäß Anspruch 20, wobei die Lochtransportschicht (130) ein Material umfasst ausgewählt aus der Gruppe bestehend aus Polythiophenen, Polyanilinen, Polyvinylcarbazolen, Polyphenylenen, Polyphenylvinylenen, Polysilanen, Polythienylenvinylenen, Polyisothianaphthanenen und Kombinationen daraus.

22. Photovoltaische Zelle (100, 520, 620) gemäß Anspruch 1, weiter umfassend eine Lochtransportschicht zwischen der aktiven Schicht (140) und der ersten Elektrode.

23. Photovoltaische Zelle (100, 520, 620) gemäß Anspruch 22, wobei die Lochtransportschicht ein Material umfasst ausgewählt aus der Gruppe bestehend aus Polythiophenen, Polyanilinen, Polyvinylcarbazolen, Polyphenylenen, Polyphenylvinylenen, Polysilanen, Polythienylenvinylenen, Polyisothianaphthanenen und Kombinationen daraus.

24. Photovoltaische Zelle (100, 520, 620) gemäß Anspruch 19, wobei die erste Elektrode eine Netzelektrode umfasst.

25. Photovoltaische Zelle (100, 520, 620) gemäß einem der Ansprüche 1 oder 4 bis 11, weiter umfassend:
eine Lochblockierende-Schicht (150) zwischen der ersten Elektrode (160) und der aktiven Schicht (140); und
eine Lochtransportschicht (130) zwischen der Netzelektrode (120) und der aktiven Schicht (140).

26. Photovoltaische Zelle (100, 520, 620) gemäß Anspruch 25, wobei die Lochtransportschicht (130) ein Material umfasst ausgewählt aus der Gruppe bestehend aus Polythiophenen, Polyanilinen, Polyvinylcarbazolen, Polyphenylenen, Polyphenylvinylenen, Polysilanen, Polythienylenvinylenen, Polyisothianaphthanenen und Kombinationen daraus.

27. Photovoltaische Zelle (100, 520, 620) gemäß Anspruch 26, wobei die Lochblockierende-Schicht (150) ein Material umfasst ausgewählt aus der Gruppe bestehend aus LiF, Metalloxiden und Kombinationen daraus.

28. Photovoltaische Zelle (100, 520, 620) gemäß Anspruch 25, wobei die Lochblockierende-Schicht (150) ein Material umfasst ausgewählt aus der Gruppe bestehend aus LiF, Metalloxiden und Kombinationen daraus.

29. Photovoltaische Zelle (100, 520, 620) gemäß Anspruch 25, wobei die erste Elektrode eine Netzelektrode umfasst.

30. Photovoltaische Zelle (100, 520, 620) gemäß Anspruch 25, weiter umfassend ein Substrat (110), das die Netzelektrode (120) trägt.

31. Photovoltaische Zelle (100, 520, 620) gemäß Anspruch 30, weiter umfassend ein haftendes Material zwischen dem Substrat (110) und der Lochtransportschicht (130).

32. Photovoltaische Zelle (100, 520, 620) gemäß Anspruch 30, wobei die Lochtransportschicht (130) in Kontakt mit dem Substrat (110) ist.

33. Photovoltaisches System (500, 600) umfassend eine Mehrzahl von photovoltaischen Zellen (520, 620) gemäß Anspruch 1 oder 25, wobei zumindest eine der Vielzahl der photovoltaischen Zellen (520, 620) elektrisch verbunden sind.

34. Photovoltaisches System (500, 600) gemäß Anspruch 33, wobei alle der Vielzahl von photovoltaischen Zellen (520, 620) elektrisch verbunden sind.

35. Photovoltaisches System (600) gemäß Anspruch 33, wobei zumindest einige der elektrisch verbundenen photovoltaischen Zellen parallel elektrisch verbunden sind.

36. Photovoltaisches System (500) gemäß Anspruch 33, wobei zumindest einige der elektrisch verbundenen photovoltaischen Zellen (520) seriell elektrisch verbunden sind.

37. Photovoltaisches System (500, 600) gemäß Anspruch 33, wobei zumindest einige der elektrisch verbundenen photovoltaischen Zellen (520, 620) parallel elektrisch verbunden mit einer Last sind.

## Revendications

1. Cellule photovoltaïque (100, 520, 620), comprenant :
une première électrode (60 (160) ;
une électrode à mailles (120) ; et
une couche active (140) entre la première électrode et l'électrode à mailles (160, 120),
**caractérisée en ce que**
la couche active (140) comprend :
un matériau accepteur d'électrons, et
un matériau donneur d'électrons ; et
l'électrode à mailles (120) comprend des mailles tissées.

2. Cellule photovoltaïque (100, 520, 620) selon la revendication 1, dans laquelle l'électrode à mailles (120) est une cathode.

3. Cellule photovoltaïque (100, 520, 620) selon la revendication 1, dans laquelle l'électrode à mailles (120) est une anode.

4. Cellule photovoltaïque (100, 520, 620) selon la revendication 1, dans laquelle les mailles comprennent un matériau électriquement conducteur.

5. Cellule photovoltaïque (100, 520, 620) selon la revendication 4, dans laquelle le matériau électriquement conducteur est choisi parmi le groupe comprenant métaux, alliages, polymères, et des combinaisons de ceux-ci.

6. Cellule photovoltaïque (100, 520, 620) selon la revendication 1, dans laquelle l'électrode à mailles (120) comprend des fils (122).

7. Cellule photovoltaïque (100, 520, 620) selon la revendication 6, dans laquelle les fils (122) comprennent un matériau électriquement conducteur.

8. Cellule photovoltaïque (100, 520, 620) selon la revendication 7, dans laquelle le matériau électriquement conducteur est choisi parmi le groupe comprenant métaux, alliages, polymères, et des combinaisons de ceux-ci.

9. Cellule photovoltaïque (100, 520, 620) selon la revendication 6, dans laquelle les fils (120) comprennent un revêtement (304) qui inclut un matériau électriquement conducteur.

10. Cellule photovoltaïque (100, 520, 620) selon la revendication 9, dans laquelle le matériau électriquement conducteur est choisi parmi le groupe comprenant métaux, alliages, polymères, et des combinaisons de ceux-ci.

11. Cellule photovoltaïque (100, 520, 620) selon la revendication 10, dans laquelle les fils (122) sont formés de matériau électriquement isolant (302) revêtu avec le revêtement (304).

12. Cellule photovoltaïque (100, 520, 620) selon la revendication 1, dans laquelle le matériau accepteur d'électrons comprend un matériau choisi parmi le groupe comprenant fullerènes, nanoparticules inorganiques, oxadiazoles, cristaux liquides discotiques, nanotiges de carbone, nanotiges inorganiques, polymères contenant des groupes CN, polymères contenant des groupes CF3, et des combinaisons de ceux-ci.

13. Cellule photovoltaïque (100, 520, 620) selon la revendication 1, dans laquelle le matériau accepteur d'électrons comprend un fullerène substitué.

14. Cellule photovoltaïque (100, 520, 620) selon la revendication 1, dans lequel le matériau donneur d'électrons comprend un matériau choisi parmi le groupe comprenant cristaux liquides discotiques, polythiophènes, polyphénylènes, polyphénylvinylènes, polysilanes, polythiénylvinylènes et polyisothianaphtalènes.

15. Cellule photovoltaïque (100, 520, 620) selon la revendication 1, dans laquelle le matériau donneur d'électrons comprend poly(3 hexylthiophène).

16. Cellule photovoltaïque (100, 520, 620) selon la revendication 1, comprenant en outre une couche de blocage de trous (150) entre la couche active (140) et la première électrode (160).

17. Cellule photovoltaïque (100, 520, 620) selon la revendication 16, dans laquelle la couche de blocage de trous (150) comprend un matériau choisi parmi le groupe comprenant LiF, oxydes métalliques, et des combinaisons de ceux-ci.

18. Cellule photovoltaïque (100, 520, 620) selon la revendication 1, comprenant en outre une couche de blocage de trous (150) entre la couche active (140) et l'électrode à mailles (120).

19. Cellule photovoltaïque (100, 520, 620) selon la revendication 18, dans laquelle la couche de blocage de trous (150) comprend un matériau choisi parmi le groupe comprenant LiF, oxydes métalliques, et des combinaisons de ceux-ci.

20. Cellule photovoltaïque (100, 520, 620) selon la revendication 1, comprenant en outre une couche porteuse de trous (130) entre la couche active (140) et l'électrode à mailles (120).

21. Cellule photovoltaïque (100, 520, 620) selon la revendication 20, dans laquelle la couche porteuse de trous (130) comprend un matériau choisi parmi le groupe comprenant polythiophènes, polyanilines, polyvinylecarbazoles, polyphénylènes, polyphénylvinylènes, polysilanes, polythiénylènevinylènes, polyisothianaphtalènes, et des combinaisons de ceux-ci.

22. Cellule photovoltaïque (100, 520, 620) selon la revendication 1, comprenant en outre une couche porteuse de trous entre la couche active (140) et la première électrode.

23. Cellule photovoltaïque (100, 520, 620) selon la revendication 22, dans laquelle la couche porteuse de trous comprend un matériau choisi parmi le groupe comprenant polythiophènes, polyanilines, polyvinylecarbazoles, polyphénylènes, polyphénylvinylènes, polysilanes, polythiénylènevinylènes, polyisothianaphtalènes, et des combinaisons de ceux-ci.

24. Cellule photovoltaïque (100, 520, 620) selon la revendication 19, dans laquelle la première électrode comprend une électrode à mailles.

25. Cellule photovoltaïque (100, 520, 620) selon l'une quelconque des revendications 1 ou 4 à 11, comprenant en outre :
une couche de blocage de trous (150) entre la première électrode (160) et
la couche active (140) ; et
une couche porteuse de trous (130) entre l'électrode à mailles (120) et la couche active (140).

26. Cellule photovoltaïque (100, 520, 620) selon la revendication 25, dans laquelle la couche porteuse de trous (130) comprend un matériau choisi parmi le groupe comprenant polythiophènes, polyanilines, polyvinylecarbazoles, polyphénylènes, polyphénylvinylènes, polysilanes, polythiénylènevinylènes, polyisothianaphtalènes, et des combinaisons de ceux-ci.

27. Cellule photovoltaïque (100, 520, 620) selon la revendication 26, dans laquelle la couche de blocage de trous (150) comprend un matériau choisi parmi le groupe comprenant LiF, oxydes métalliques, et des combinaisons de ceux-ci.

28. Cellule photovoltaïque (100, 520, 620) selon la revendication 25, dans laquelle la couche de blocage de trous (150) comprend un matériau choisi parmi le groupe comprenant LiF, oxydes métalliques, et des combinaisons de ceux-ci.

29. Cellule photovoltaïque (100, 520, 620) selon la revendication 25, dans laquelle la première électrode comprend une électrode à mailles.

30. Cellule photovoltaïque (100, 520, 620) selon la revendication 25, comprenant en outre un substrat (110) supportant l'électrode à mailles (120).

31. Cellule photovoltaïque (100, 520, 620) selon la revendication 30, comprenant en outre un matériau adhésif entre le substrat (110) et la couche porteuse de trous (130).

32. Cellule photovoltaïque (100, 520, 620) selon la revendication 30, dans laquelle la couche porteuse de trous (130) est en contact avec le substrat (110).

33. Système photovoltaïque (500, 600) comprenant une pluralité de cellules photovoltaïques (520, 620) selon la revendication 1 ou 25, dans lequel au moins certaines des cellules photovoltaïques (520, 620) de ladite pluralité sont électriquement connectées.

34. Système photovoltaïque (500, 600) selon la revendication 33, dans lequel toutes les cellules de la pluralité de cellules photovoltaïques (520, 620) sont électriquement connectées.

35. Système photovoltaïque (600) selon la revendication 33, dans lequel au moins certaines des cellules photovoltaïques (620) électriquement connectées sont électriquement connectées en parallèle.

36. Système photovoltaïque (500) selon la revendication 33, dans lequel au moins certaines des cellules photovoltaïques (520) électriquement connectées sont électriquement connectées en série.

37. Système photovoltaïque (500, 600) selon la revendication 33, dans lequel au moins certaines des cellules photovoltaïques (520, 620) électriquement connectées sont électriquement connectées à une charge en parallèle.
